# EUROPEAN PATENT APPLICATION

(11) **EP 2 615 852 A2**
(43) Date of publication of application: **17.07.2013**
(21) Application number: 12195968.8
(22) Date of filing: 06.12.2012
(51) Int. Cl.: H04R 3/12

(54) **Terminal having plural audio signal output ports and audio signal output method thereof**

(30) Priority: 13.01.2012 KR 20120004401
(71) Applicant: Samsung Electronics Co., Ltd, Gyeonggi-do 443-742 (KR)
(72) Inventor: Lim, Jihyuk, 443-742 Gyeonggi-do, (KR)
(74) Representative: Harrison Goddard Foote LLP

(57) **Abstract**

A terminal having plural audio signal output ports and an audio signal output method thereof are provided. The audio signal output method of a terminal having at least two audio signal output ports includes setting allocation information on which audio signal source is allocated to each of the audio signal output ports according to a user input, extracting the set allocation information, and outputting an audio signal of an audio signal source through a corresponding audio signal output port according to the extracted allocation information. An audio signal output apparatus capable of variously using an audio signal output port according to the need of a user, and a method thereof may be provided.

## Description

### BACKGROUND OF THE INVENTION

### 1. Field of the Invention:

The present invention relates to an audio signal output method and apparatus. More particularly, the present invention relates to a terminal having plural audio signal output ports and an audio signal output method thereof.

### 2. Description of the Related Art:

A portable terminal or a home terminal outputs an audio signal through an audio signal output port in many cases. For example, a radio including an ear jack module into which an ear jack is inserted outputs an audio signal through an ear jack. When inserting the ear jack into the ear jack module, the user may listen to a sound format converted from an audio signal output from the radio into.

In recent years, a plurality of core central processing units or a large screen is applied to a terminal thereby resulting in significant development of the performance of the terminal. Accordingly, one terminal simultaneously executes two applications or more. More particularly, there is a problem in a case in which simultaneously executing at least two image/audio playback applications or at least two image/audio contents are simultaneously played in one application. In this case, if all audio signals from at least two audio signal sources are outputted through one audio signal output port, two overlapped audios are provided to a user. An approach including at least two audio signal output ports, for example, at least two ear phone jack modules has been suggested to solve the problem.

With development of an audio processing technique, an application or contents outputting an audio signal through four channels or more has widely been used including an existing stereo channel.

More particularly, when a terminal includes a plurality of audio signal output ports, there is a need to diversify a used scheme of an audio signal output port according to the need of a user.

Therefore, a need exists for a method and apparatus capable of variously using an audio signal output port according to the need of a user.

The above information is presented as background information only to assist with an understanding of the present disclosure. No determination has been made, and no assertion is made, as to whether any of the above might be applicable as prior art with regard to the present invention.

### SUMMARY OF THE INVENTION

An aspect the present invention is to address at least the above-mentioned problems and/or disadvantages and to provide at least the advantages described below. Accordingly, an aspect of the present invention is to provide an audio signal output apparatus capable of variously using an audio signal output port according to the need of a user, and a method thereof.

In accordance with an aspect of the present invention, audio signal output method of a terminal including at least two audio signal output ports is provided. The method includes, setting allocation information on which audio signal source is allocated to each of the at least two audio signal output ports according to a user input, extracting the set allocation information, and outputting an audio signal of the allocated audio signal source through a corresponding audio signal output port according to the extracted allocation information.

In accordance with another aspect of the present invention, a terminal for outputting an audio signal is provided. The terminal includes, at least two audio signal output ports, an allocation setter for setting allocation information on which audio signal source is allocated to each of the at least two audio signal output ports according to a user input, and a signal output unit for extracting the set allocation information, and for outputting an audio signal of the allocated audio signal source through a corresponding audio signal output port according to the extracted allocation information.

In accordance with another aspect of the present invention, a terminal for outputting an audio signal is provided. The terminal includes an input unit for receiving user input, a display for display a graphical user interface; at least two audio signal output ports, and a controller that is configured to operatively receive user input corresponding to a setting for allocating an audio signal source to each of the at least two audio signal output ports, and to operatively output via the at least two audio signal output ports the allocated audio signal allocated to the corresponding audio signal output port based on the user input.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description taken in conjunction with the accompanying drawings, in which:

FIG. 1A is a block diagram illustrating a configuration of a terminal according to an exemplary embodiment of the present invention;

FIG. 1B is a diagram illustrating an earphone jack coupled with a terminal according to an exemplary embodiment of the present invention;

FIG. 2 is a flowchart illustrating a method of outputting an audio signal according to an exemplary embodiment of the present invention;

FIG. 3 is a flowchart illustrating a step of setting allocation information of an audio signal according to an input of a user such as, for example, step 220 of FIG. 2 in detail according to an exemplary embodiment of the present invention;

FIGs. 4A to 4E are diagrams illustrating a user allocation setting input interface according to a first exemplary embodiment of the present invention;

FIGs. 5A and 5B are diagrams illustrating a user allocation setting input interface according to a second exemplary embodiment of the present invention;

FIGs. 6A and 6B are diagrams illustrating a user allocation setting input interface according to a third exemplary embodiment of the present invention; and

FIGs. 7A and 7B are diagrams illustrating an operation of a switch for connecting audio signal output ports to an audio signal source according to an exemplary embodiment of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

In the specification, an audio signal source is a program unit which generates an audio signal to be processed in one audio signal output port. For example, an application of a terminal generating an audio signal may be an audio signal source. However, when one application generates at least two independent audio signals, an object generating the audio signal may be an independent audio signal source. For example, when one plays at least two images, each of image playback objects may be an independent audio signal source. For example, when one audio signal output port may output an audio signal through two channels, a game program outputting four channel audio signals may include two audio signal sources, for example, a front audio signal source (first and second channels) and a rear audio signal source (third and fourth channels). According to an exemplary embodiment, one audio signal output port may include only one channel or at least three channels.

As used herein, the term "allocation information" refers to information on which audio signal output port outputs an audio signal of an audio signal source.

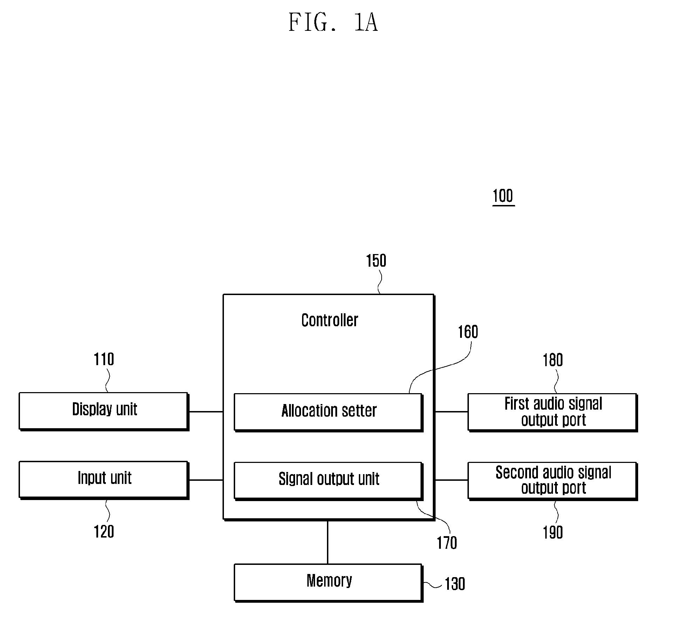

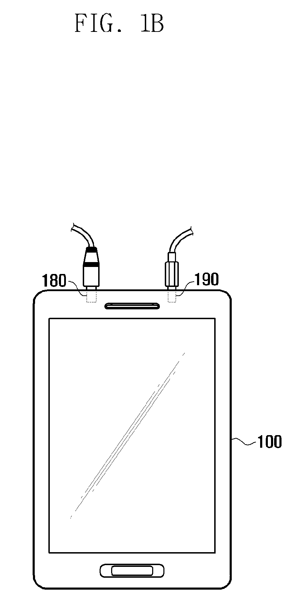

FIG. 1A is a block diagram illustrating a configuration of a terminal 100 according to an exemplary embodiment of the present invention. FIG. 1B is a diagram illustrating an earphone jack coupled with a terminal according to an exemplary embodiment of the present invention.

Referring to FIG. 1A, a terminal 100 according to an embodiment of the present invention includes a display unit 110, an input unit 120, a memory 130, a controller 150, a first audio signal output port 180, and a second audio signal output port 190.

The first audio signal output port 180 and the second audio signal output port 190 receive and output an audio signal from the controller 150. For example, the first audio signal output port 180 and the second audio signal output port 190 may be implemented in the form of an earphone jack module into which an ear jack can be inserted. The user may fitting-engage an earphone jack or a speak jack with the first audio signal output port 180 to listen to an audio signal outputted from the terminal in a converted sound form. Each of the first audio signal output port 180 and the second audio signal output port 190 may support two channels, that is, stereo channel. To do this, the first audio signal output port 180 and the second audio signal output port 190 may include two output contacts. For example, the earphone jack module may be implemented in two cylindrical coupled insertion ports having different diameters. Each of the two cylindrical insertion ports may include one output contact. Supporting a stereo channel of the audio signal output port is generally known in the art, thus a detailed description thereof is omitted.

Referring to FIG. 1B, an earphone jack is coupled with the first audio signal output port 180 and the second audio signal output port 190.

Referring to FIG. 1A, the display unit 110 visually provides a menu of the terminal 100, input data, function setting information and other various information to the user. The display unit 110 performs a function of outputting a booting screen, an idle screen, a menu screen, a call screen, and other application screens. The display unit 110 may be configured by a Liquid Crystal Display (LCD), an Organic Light Emitting Diode (OLED), an Active Matrix Organic Light Emitting Diode (AMOLED), and the like.

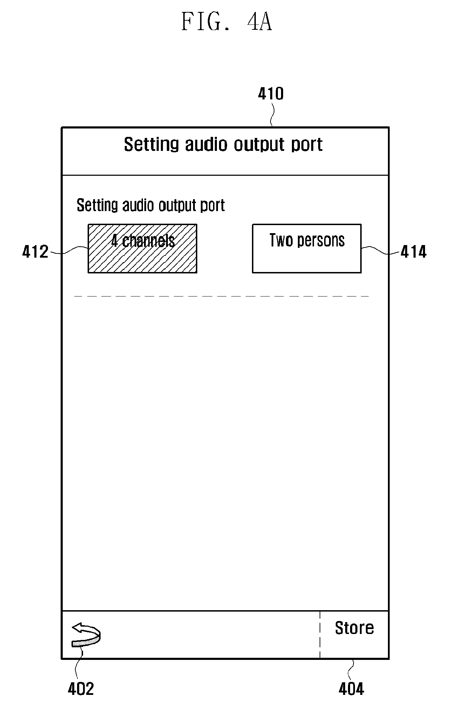

More particularly, the display unit 100 according to an exemplary embodiment of the present invention may display allocation information on audio signals of which the first audio signal output port 180 and the second audio signal output port 190 output, respectively. The display unit 110 provides an interface capable of receiving user allocation setting together with the input unit 120. If the user allocation setting is inputted, the controller 150 may set allocation information on an audio signal of which an audio signal source the first audio signal output port 180 and the second audio signal output port 190 output according to user allocation setting, respectively. A concrete configuration and an interface according to an exemplary embodiment of the present invention will be described with reference to FIGs. 4A to 6B below.

The input unit 120 may be implemented in the form of a key pad and/or a touch sensor. When the input unit 120 is implemented in the form of the touch sensor, the display unit 110 and the input unit 120 may be coupled with each other to configure a touch screen.

The touch sensor detects a touch input of the user. The touch sensor may be configured by a capacitive overlay sensor, a resistive overlay sensor, an infrared beam sensor, a pressure sensor, or the like. Various types of sensor devices capable of detecting contact or pressure of an object may be configured as a touch sensor in addition to the foregoing sensors. The touch sensor detects a touch input of the user and generates and transmits a detection signal to the controller 150. The detection signal includes coordinates data corresponding to a location at which the user inputs the touch. When the user inputs a touch location moving operation, the touch sensor generates the detection signal including coordinates data of a touch location moving path to the controller 150.

The key pad receives a key operation of the user for controlling the terminal 100 and generates and transfers an input signal to the controller 150. The key pad may include numeric keys and arrow keys. The key pad may be provided in one side of the terminal as a predetermined function key. According to an exemplary embodiment of the present invention, the key pad may be omitted in a terminal capable of performing all operations by only a touch sensor.

More particularly, the input unit 120 according to an exemplary embodiment of the present invention provides an interface capable of receiving user allocation setting together with the display unit 110. The input unit 120 may receive the user allocation setting. If the input unit 120 receives the user allocation setting, the controller 150 may set allocation information on an audio signal of which audio signal source the first audio signal output port 180 and the second audio signal output port 190 output according to the user allocation setting, respectively. A concrete configuration and an interface according to an exemplary embodiment of the present invention will be described with reference to FIGs. 4A to 6B below.

The memory 130 stores programs and data necessary for an operation of the terminal 100. The memory 130 may be divided into a program area and a data area. The program area may store a program controlling an overall operation of the terminal 100, an operating system booting the terminal 100, an application program necessary for playing multi-media contents, and an application program necessary for other option functions of the terminal 100, for example, a camera function, a sound playback function, and an image or moving image playback function. The data area may store data generated according to use of the terminal 100, images, moving pictures, phone-books, audio data, and the like.

More particularly, the memory 130 according to an exemplary embodiment of the present invention stores allocation information on an audio signal of which audio signal source is outputted. The controller 150 may update allocation information stored in the memory 130. The controller 150 may search the memory 130 to extract allocation information on audio signals of which audio signal sources the audio signal output ports 180 and 190 output, respectively.

The controller 150 controls an overall operation of respective constituent elements of the terminal 100. In particular, the controller 150 according to the embodiment of the present invention controls the display unit 110 and an input unit so that an interface capable of receiving user allocation setting is provided. The controller 150 executes applications including an audio playback application and an image playback application. An application having an audio output among executed applications may be an audio signal source.

According to exemplary embodiments of the present invention, the controller 150 includes an allocation setter 160 and a signal output unit 170. The allocation setter 160 receives user allocation setting from the input unit 120 and sets allocation information stored in the memory 130 according the user allocation setting. The signal output unit 170 extracts the set allocation information and outputs the extracted set allocation information through the first or second audio signal output port 180 or 190 corresponding to the audio signal of the audio signal source.

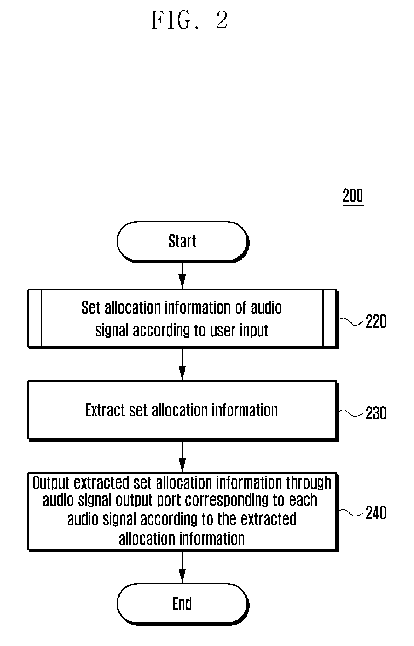

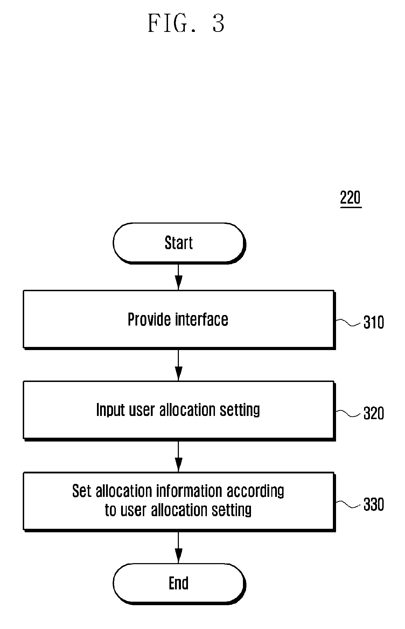

A detailed operation of constituent elements of the terminal 100 will be described with reference to FIGs. 2 and 3.

FIG. 2 is a flowchart illustrating a method of outputting an audio signal according to an exemplary embodiment of the present invention.

Referring to FIG. 2, an allocation setter 160 sets allocation information of an audio signal according to an input of the user at step 220.

A detailed description of step 220 will be made with reference to FIG. 3.

A signal output unit 170 extracts the set allocation information at step 230.

The signal output unit 170 outputs the extracted set allocation information through an audio signal output port 180 corresponding to each audio signal according to the extracted allocation information at step 240.

For example, the allocation information may be set in the form of a following Table 1.

**Table 1**

| Audio signal output port | First audio signal output port | Second audio signal output port |
|---|---|---|
| Audio signal source | Music player | Moving picture Player |

According to the allocation information of the Table 1, the signal output unit 170 outputs an audio signal which plays music of the music player through the first audio signal output port 180. The signal output unit 170 outputs an audio signal among signals playing a moving picture of the moving picture player through the second audio signal output port 190. The user may listen to a music played by the music player through an earphone and other audio signal converter inserted in the first audio signal output port 180. The user may listen to a voice of a moving picture played by the moving picture player through the earphone inserted in the second audio signal output port 180.

As illustrated in a following Table 2, setting of not using a specific audio signal output port is possible.

**Table 2**

| Audio signal output port | First audio signal output port | Second audio signal output port |
|---|---|---|
| Audio signal source | Music player | Not output |

As illustrated in a following Table 3, an audio signal may be output to both the first audio signal output port and the second audio signal output port.

**Table 3**

| Audio signal output port | First audio signal output port | Second audio signal output port |
|---|---|---|
| Audio signal source | Music player | Music player |

As illustrated in a following Table 4, an audio signal output port may support a stereo channel. For example, each of the first audio signal output port and the second audio signal output port may support two channels.

**Table 4**

| Audio signal output port | First audio signal output port | Second audio signal output port |
|---|---|---|
| Audio signal source | Moving picture | Moving picture |
| | Player | Player |
| | (channels 1, 2) | (channels 3, 4) |

As illustrated in a following Table 5, when one application moving picture player simultaneously plays at least two moving pictures, two audio signal output ports may set to output an audio signal corresponding to each moving picture.

**Table 5**

| Audio signal output port | First audio signal output port | Second audio signal output port |
|---|---|---|
| Audio signal source | Moving picture | Moving picture |
| | Player (left playback) | Player (right playback) |

It is assumed in the foregoing examples that there are two audio signal output ports, but at least three audio signal output ports are equally applicable.

FIG. 3 is a flowchart illustrating a step of setting allocation information of an audio signal according to an input of a user such as, for example, step 220 of FIG. 2 in detail according to an exemplary embodiment of the present invention.

Referring to FIG. 3, a controller 150 provides an interface capable of inputting user allocation setting through a display unit 110 and an input unit 120 at step 310. The user allocation setting refers an input of the user on audio signal of which an audio signal source the audio signal output ports 180 and 190 output, respectively.

The input unit 120 receives the user allocation setting from the user and transfers the received user allocation setting to an allocation setter 160 at step 320.

The allocation setter 160 sets allocation information according to the user allocation setting at step 330. The setting allocation information is as illustrated in Tables 1 to 5.

FIGs. 4A to 4E are diagrams illustrating a user allocation setting input interface according to a first exemplary embodiment of the present invention.

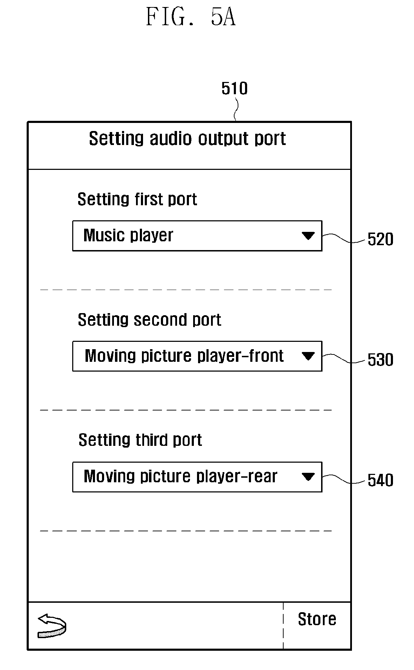

Referring to FIG. 4A, an audio output port setting initial screen 410 according to the first exemplary embodiment of the present invention is shown. The screen 410 includes a release button 402 and a storing button 404. When the user presses the release button 402 on a screen of FIGs. 4A to 5B, a change item on the screen is released. Meanwhile, when the user presses the storing button 404 on a screen of FIGs. 4A to 5B, the change item is stored. Hereinafter, a description of a release button 402 and a storing button 404 on another screen is omitted.

The screen 410 includes a 4 channels button 412 and a 2 persons sharing button 414. The display unit 110 may make visual display, for example, a display of a shadow in a button or two buttons corresponding to the current setting or a display in different colors to inform the user of which setting is currently selected. The screen 410 is in a state that 4 channels setting corresponding to a current 4 channels button 412 is selected. As the foregoing examples of the Table 4, the 4 channels setting is setting which output an audio signal corresponding to two difference channels among audio signals generated from one image of a moving picture player or the same game. A 2 persons sharing setting corresponding to the 2 persons sharing button 414 is setting which outputs an audio signal corresponding to different applications (contents) by two audio signal output ports as the example of the Table 1.

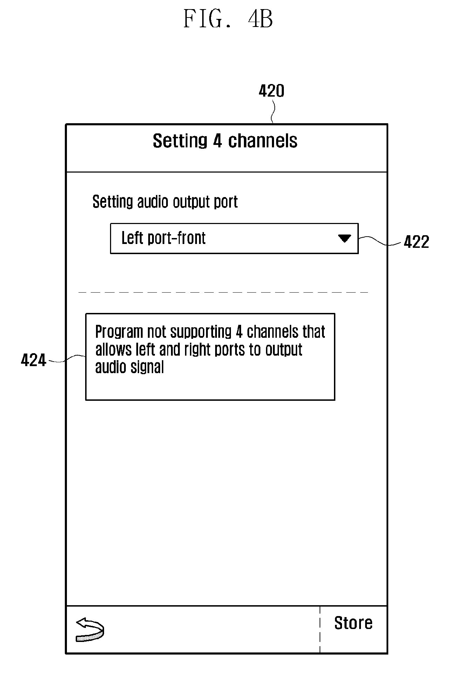

If the user selects the 4 channels button 412, a 4 channels setting screen 420 of FIG. 4B is provided. The screen 420 includes a drop-down menu 422 on voice signals of which channels the audio signal output port 180 are to be set to output, respectively. The screen 420 may include a guide message 424. The guide message 424 indicates a program which does not support four channels that allows left and right ports, that is, the first audio signal output port 180 and the second audio signal output port 190 to output the same audio signal, respectively. The guide message is to help understand of the user, which is not essential in the function.

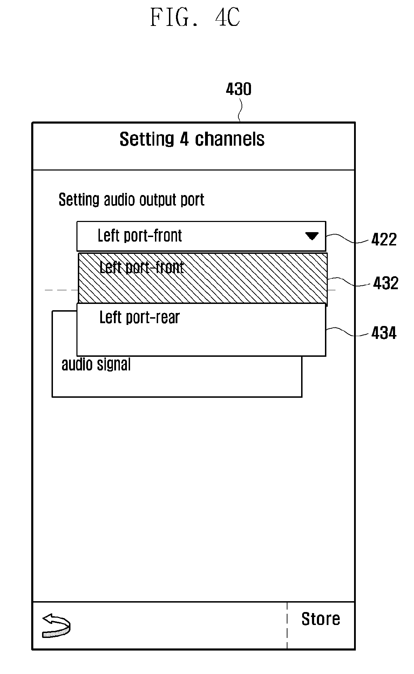

If the user selects the drop-down menu 422, a screen 430 of FIG. 4C is provided. The user may select one from two items 432 and 434 to set an audio signal of which channels the left port is to be set to output.

For example, the user selects a first item 432 and presses the storing button, the left port, that is, the first audio signal output port 180 outputs an audio signal of a front channel (first and second channels). In this case, the right terminal, that is, the second audio signal output terminal 190 outputs an audio signal of the rear channel (third and fourth channels).

Meanwhile, when the user selects a second item 432 and presses a storing button, a left port, that is, the first audio signal output port 180 outputs an audio signal of a rear channel (third and fourth channels). In this case, a right port, that is, the second audio signal output port 190 outputs a front channel (first and second channels).

According to a modified exemplary embodiment of the present invention, when the user selects a 4 channels button 412, the terminal 100 does not provide an additional setting screen 4C of FIG. 4B and may automatically select fundamental setting, for example, the first audio signal output port 180 outputs an audio signal of the front channel (first and second channels) and the second audio signal output port 190 outputs an audio signal of a rear channel (third and fourth channels). In this case, changed contents are not applicable until the storing button 404 is selected.

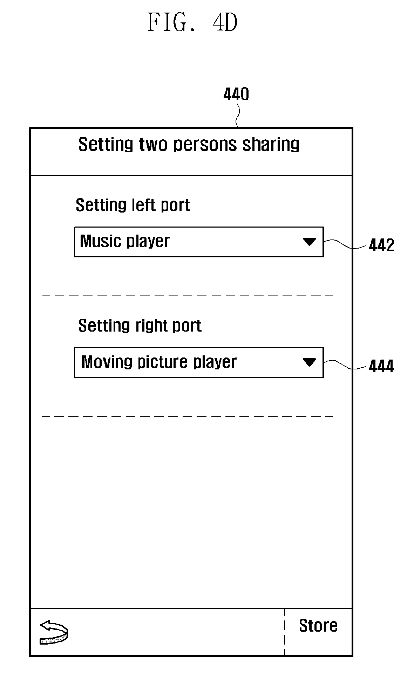

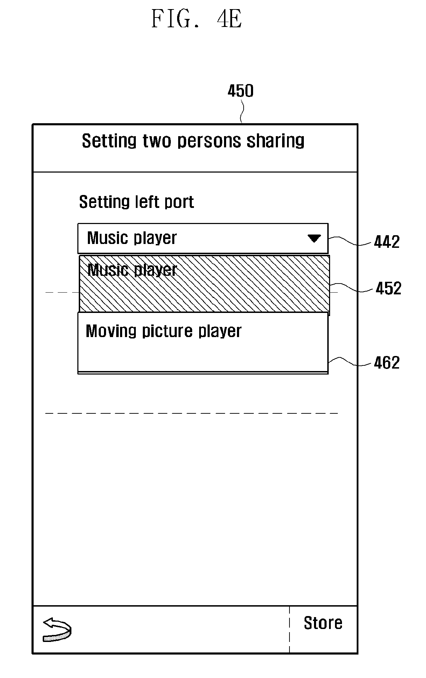

Referring to FIG. 4A, if the user selects a 2 persons sharing button 414, a 2 person sharing setting screen 440 of FIG. 4D may be provided. A screen includes a left port setting drop-down menu 442 and a right port setting drop-down menu 444. For convenience, it is assumed that the left port is the first audio signal output port 180 and the right port is the second audio signal output port 190. If the user selects a drop-down menu 442, a two persons sharing screen 450 of FIG. 4E is provided. The drop down menu 442 includes audio signal source items 452 and 462 capable of being allocated to the left port are provided in the form of a list. Presently, the first audio signal output port 180 is set to output an audio signal of an audio signal source corresponding to the first item 452, that is, the music player. If the user selects the second item 462, the first audio signal output port 180 is set to output an audio signal of a moving picture player corresponding to the first item 452.

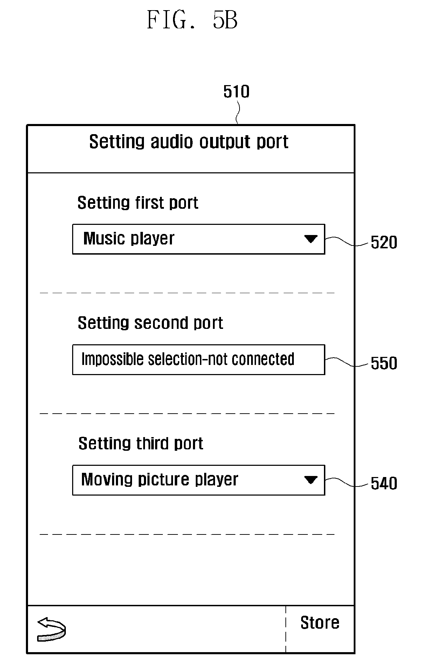

It is assumed in the exemplary embodiment of the present invention that the terminal 100 includes two audio signal output ports 180 and 190. As the embodiment of FIGs. 5A and 5B, the terminal 100 may include three audio signal output terminals or more.

FIGs. 5A and 5B are diagrams illustrating a user allocation setting input interface according to a second exemplary embodiment of the present invention.

FIG. 5A illustrates an audio output port setting screen 510. The screen 510 includes drop-down menus 520, 530, and 540 capable of setting three audio output ports. In the same manner as illustrated in FIGs. 4B to 4E, the user may change setting of the audio signal output ports by selecting the drop-down menu. According to the screen 510, the terminal 100 is set such that a first port outputs an audio signal of a music player, and a second port and a third port output a front channel (first and second channels) of a moving picture player and a rear channel (third and fourth channels), respectively.

According to a modified exemplary embodiment of the present invention, the controller 150 detects a connection state of an audio output port to change an interface to be provided to the user. For example, assuming that a second audio output port is not connected to an earphone jack in FIG. 5A, the controller 150 inactivates a combo box 550 with respect to the second audio output port and sets the combo box 550 in a state that the user may not select.

According to the exemplary embodiment of the present invention of FIGs. 5A to 5B, unlike the exemplary embodiment of the present invention of FIGS. 4A to 4E, an interface in a scheme of allocating an audio signal source of each audio signal output port not a 4 channels button and a 2 persons setting button is provided.

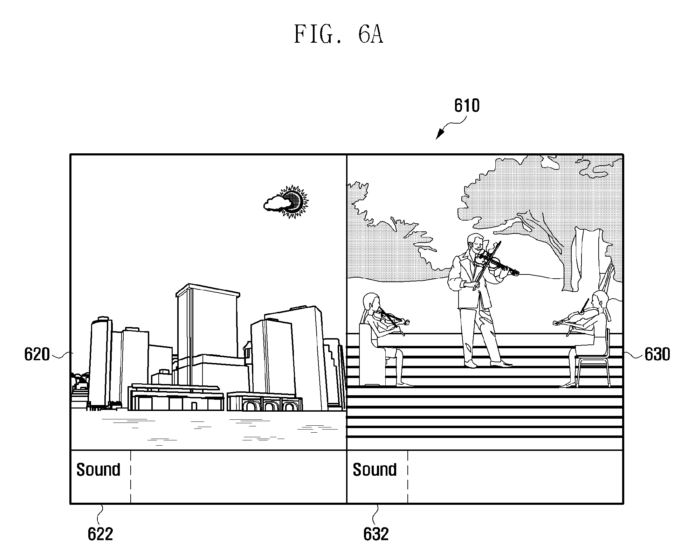

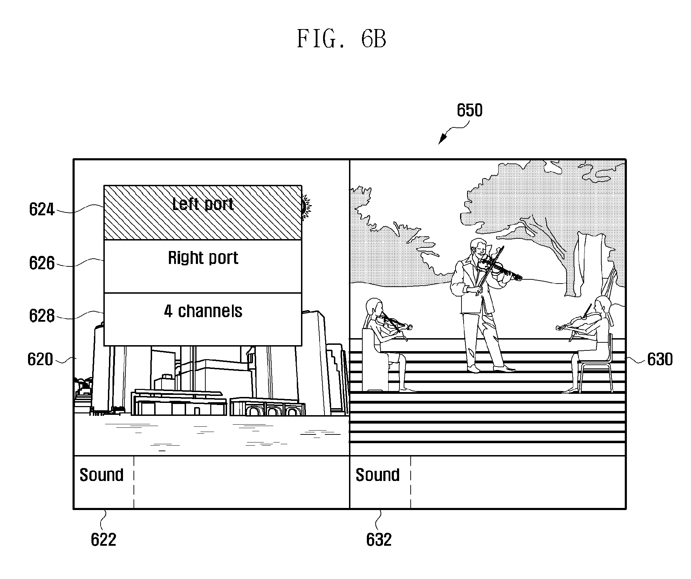

FIGs. 6A and 6B are diagrams illustrating a user allocation setting input interface according to a third exemplary embodiment of the present invention.

Referring to FIG. 6A, a full screen 610 is divided into a first screen 620 and a second screen 630. It is assumed that different moving pictures are simultaneously played through the first screen 620 and the second screen 630. The user may select a sound button 622 or 632 on the screen 610 to change setting of the audio signal output port.

If the user selects the sound button 622, the screen 650 of FIG. 6B is displayed. Referring to FIG. 6B, a menu capable of selecting through which scheme a sound corresponding to a playback image of a left screen 620 is output in the form of a pop-up window or a similar form thereto. A menu includes a left port item 624, a right port item 626, and a 4 channel item 628. If the user selects the left port item 624, an audio signal corresponding to a left screen 620 is outputted through the left audio output port. If the user selects the right port item 626, an audio signal corresponding to a right screen 630 is outputted through the right audio output port. If the user selects the 4 channel 628, a front channel (first and second channels) among audio signals corresponding to the left screen 620 is outputted through a left audio output port, and a rear channel (third and fourth channels) among audio signals corresponding to the right screen 630 is outputted through a right audio output port.

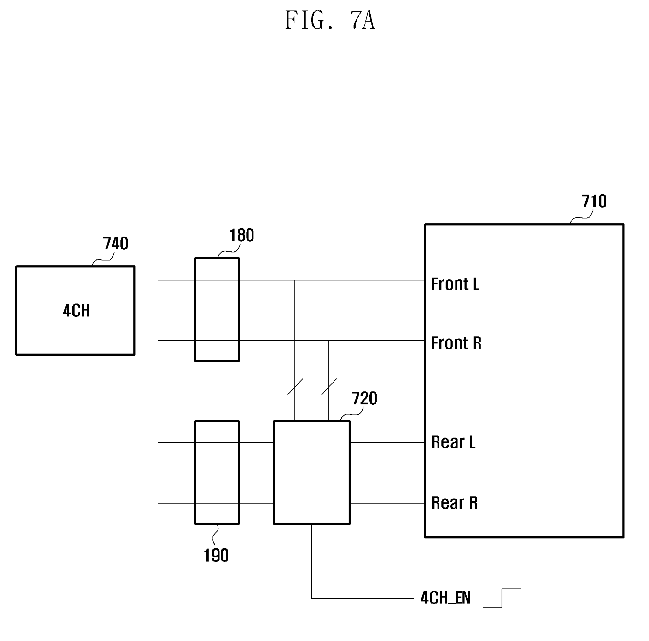

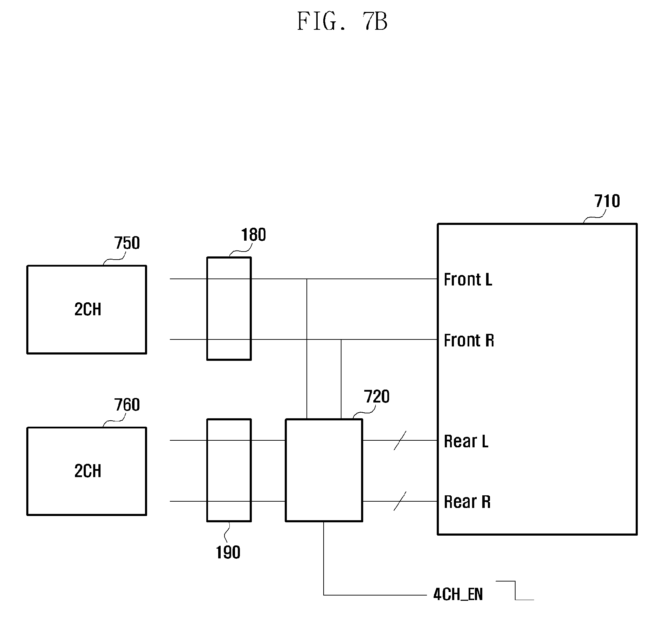

FIGs. 7A and 7B are diagrams illustrating an operation of a switch 720 for connecting audio signal output ports 180 and 190 to an audio signal source 710 according to an exemplary embodiment of the present invention. According to the exemplary embodiment of the present invention, the signal output unit 170 may include a switch 720 as illustrated in FIGs. 7A and 7B.

Referring to FIG. 7A, the switch 720 connects a front channel among audio signals of one moving picture to the first audio signal output port 180 and connects a rear channel among audio signals of the same moving picture to the second audio signal output port 190 according to allocation information. The user 740 may receive a 4 channels sound.

Referring to FIG. 7B, the switch 720 connects both of the first audio signal output port 180 and the second audio signal output port 190 to the front channel. Two users 750 and 760 may receive 2 channel sounds, respectively.

The switch 720 may operate in the form of FIG. 7A or FIG. 7B according to a signal from another constituent element, for example, a 4CH_EN signal.

The exemplary embodiment of the present invention can provide an audio signal output apparatus capable of variously using an audio signal output port according to the need of a user, and a method thereof.

Here, it will be appreciated that combinations of process flowcharts and respective blocks thereof may be achieved by instructions of a computer program. Because instructions of a computer program may be mounted in a processor of a general-purpose computer, a special computer, or programmable data processing equipment, they generate means for executing functions described in flowchart block(s). Because the instructions of a computer program may be stored in a computer usable or readable memory of a computer or a programmable data processing equipment to implement a function in a specific way, they may produce manufacturing goods including instruction means executing functions described in flowchart block(s). Because the instructions of a computer program may be mounted in a computer or a programmable data processing equipment, a series of operation stages are executed on the computer or the programmable data processing equipment to produce a process executed by the computer such that the instructions executing the computer or the programmable data processing equipment may provide stages for executing functions described in flowchart block(s).

Further, each block may indicate a part of a module including at least one executable instruction for executing specific logical function(s), a segment, and a code. In substitute execution exemplary embodiments, it should be noticed that functions mentioned in blocks may be created beyond an order. Two sequentially shown blocks may be performed really and simultaneously or be performed in a reverse order according to a corresponding function. As used in this exemplary embodiment, the term '∼ unit' means a software, or a hardware structural element such as FPGA or ASIC, and performs some functions. However, '∼ unit' is not limited to the software or hardware. A '∼ unit' may be configured in an addressable storing medium to play at least one processor. Accordingly, for example, '- unit' includes software structural elements, object-oriented software structural elements, class structural elements, task structural elements, processes, functions, attributes, procedures, sub-routines, segments of a program code, drivers, firmware, micro code, circuit, data, database, data structures, tables, arrays, and variables. Functions provided to structural elements and ' - units may be combined by a smaller number of structural elements and ' - unit's or divided into additional structural elements and '- units. In addition, structural elements and ' - unit's may be implemented to play at least one CPU in a device or security multimedia card.

As a non-exhaustive illustration only, a terminal described herein may refer to mobile devices such as a cellular phone, a Personal Digital Assistant (PDA), a digital camera, a portable game console, and an MP3 player, a Portable/Personal Multimedia Player (PMP), a handheld e-book, a portable lap-top Personal Computer (PC), a Global Positioning System (GPS) navigation, and devices such as a desktop PC, a High Definition TeleVision (HDTV), an optical disc player, a setup box, and the like capable of wireless communication or network communication consistent with that disclosed herein.

Although the invention has been shown and described in detail with reference to certain exemplary , it will be understood by those skilled in the art that various changes in form and details may be made therein without departing from the spirit and scope of the present invention as defined in the appended claims and their equivalents.

## Claims

1. An audio signal output method of a terminal comprising at least two audio signal output ports, the method comprising:
setting allocation information on which audio signal source is allocated to each of the at least two audio signal output ports according to a user input;
extracting the set allocation information; and
outputting an audio signal of the allocated audio signal source through a corresponding audio signal output port according to the extracted allocation information.

2. The method of claim 1, wherein the setting of the allocation information comprises:
providing an interface capable of receiving a user allocation setting;
receiving the user allocation setting through the interface; and
setting the allocation information according to the received user allocation setting.

3. The method of claim 2, wherein the providing of the interface comprises providing an interface capable of selecting one of:
a setting such that a plurality of audio signal output ports of the at least two audio signal output ports correspond to audio signal sources of different channels of an audio signal constituting one contents; and
a setting such that the at least two audio signal output ports correspond to an audio signal source constituting contents.

4. The method of claim 2, wherein the providing of the interface comprises providing an interface capable of selecting the audio signal source corresponding to each of the at least two audio signal output ports.

5. The method of claim 4, wherein the providing of the interface comprises providing an interface capable of selecting the audio signal source including the same number of a partial channel of one contents as the number of channels as an audio signal source corresponding to an audio signal output port.

6. The method of claim 4, wherein the providing of the interface comprises providing a limited interface such that the audio signal source is not selected with respect to an audio signal output port to which an external device is not connected.

7. A terminal for outputting an audio signal, the terminal comprising:
at least two audio signal output ports;
an allocation setter for setting allocation information on which audio signal source is allocated to each of the at least two audio signal output ports according to a user input; and
a signal output unit for extracting the set allocation information, and for outputting an audio signal of the allocated audio signal source through a corresponding audio signal output port according to the extracted allocation information.

8. The terminal of claim 7, wherein the allocation setter provides an interface capable of receiving a user allocation setting,
wherein the terminal receives the user allocation setting through the interface, and
wherein the allocation setter sets the allocation information according to the received user allocation setting.

9. The terminal of claim 8, wherein the allocation setter provides an interface capable of selecting one of:
a setting such that a plurality of audio signal output ports of the at least two audio signal output ports correspond to audio signal sources of different channels of an audio signal constituting one contents; and
a setting such that the at least two audio signal output ports correspond to an audio signal source constituting contents.

10. The terminal of claim 8, wherein the allocation setter provides an interface capable of selecting the audio signal source corresponding to each of the at least two audio signal output ports.

11. The terminal of claim 10, wherein the allocation setter provides an interface capable of selecting the audio signal source including the same number of a partial channel of one contents as the number of channels as an audio signal source corresponding to an audio signal output port.

12. The terminal of claim 10, wherein the allocation setter provides a limited interface such that the audio signal source is not selected with respect to an audio signal output port to which an external device is not connected.

13. The terminal of claim 7, wherein the signal output unit comprises a switch for connecting the audio output port to the audio signal source according to the allocation information.
